# EUROPEAN PATENT APPLICATION

(11) **EP 4 369 099 A1**
(43) Date of publication of application: **15.05.2024**
(21) Application number: 22861572.0
(22) Date of filing: 27.07.2022
(51) Int. Cl.: G03F 7/004, G03F 7/038, G03F 7/20

(54) **CHEMICALLY AMPLIFIED POSITIVE PHOTORESIST COMPOSITION FOR IMPROVING PATTERN PROFILE AND RESOLUTION**

(30) Priority: 23.08.2021 KR 20210110962
(71) Applicant: Ycchem Co., Ltd., Gyeongsangbuk-do 40046 (KR)
(72) Inventor: LEE, Su Jin, Daegu 42634 (KR); CHOI, Young Cheol, Gumin-si Gyeongsangbuk-do 39179 (KR); LEE, Seung Hun, Dalseong-gun Daegu 42918 (KR); LEE, Seung Hyun, Daegu 42747 (KR)
(74) Representative: Ter Meer Steinmeister & Partner
(86) International application number: PCT/KR2022/011025
(87) International publication number: WO 2023/027360

(57) **Abstract**

The present disclosure relates to a chemically amplified positive photoresist composition for improving a pattern profile and resolution. The chemically amplified positive photoresist composition is characterized by including, based on the total weight of the composition, 5 to 60 wt% of a polymer resin, 0.1 to 5 wt% of an under-pattern acid generating aid monomer additive represented by Formula 1 to Formula 3, 0.05 to 10 wt% of a photo acid generator, 0.01 to 5 wt% of an acid dispersion inhibitor, and the remainder of a solvent. The chemically amplified positive photoresist composition provides an improved vertical profile and improved resolution and sensitivity compared to conventional positive photoresists and does not generate residual scum. Thus, the chemically amplified positive photoresist composition has excellent process margins.

## Description

### Technical Field

In recent years, advances in semiconductor manufacturing process technology have led to the miniaturization and high-density integration of semiconductor devices, requiring technologies to form ultra-fine patterns with line widths of tens of nm or less. Advances in the technology for forming these ultra-fine patterns have been driven by the development of light sources with smaller wavelengths, the development of process technologies according to the light sources, and the development of photoresists suitable for the light sources.

A photoresist is used in photolithography to create various patterns. A photoresist is a photosensitive resin that changes in solubility in the developer under the action of light, making it possible to obtain an image corresponding to the exposure pattern.

To form such photoresist patterns, negative tone development (NTD) using a negative tone developer and positive tone development (PTD) using a positive tone developer are used.

The pattern formation method using a negative tone developer is to form a pattern by selectively dissolving and removing non-exposed areas with the negative tone developer, and the pattern formation method using a positive tone developer is to form a pattern by selectively dissolving and removing exposed areas with the positive tone developer.

Compared to the pattern formation method using a negative tone developer, the pattern formation method using a positive tone developer enables the pattern to be formed more effectively by implementing a reverse phase pattern when forming a contact hole pattern or a trench pattern, which is difficult to form due to insufficient exposure, and by using an organic solvent as a developer to remove a non-exposed area.

In general, the photolithography using a photoresist composition includes a process of applying a photoresist on a wafer, a soft-baking process of heating the applied photoresist to evaporate the solvent contained in the photoresist, an imaging process of imaging light originating in a light source and passing through a photomask, a process of forming a pattern by using the difference in solubility of the exposed and unexposed areas using a developer, and an etching process to complete a circuit.

The photoresist composition includes a photo acid generator that generates acid when irradiated with an excimer laser, a base resin, and additives. Polystyrene polymer having hydroxyl groups in the phenolic structure thereof is typically used as the base resin. As the photo acid generator, any material that can generate acid (H+) at a certain wavelength can be used. Mostly, sulfonium salts, sulfonyl dioxide-based, benzosulfonyl-based, iodine-based, chlorine-based, and carboxylic acid-based materials are used.

In addition, the light sources mainly used for the processes are in the wavelength range of 365 nm to 193 nm, and I-ray, KrF excimer laser, and ArF excimer laser light sources are mainly used. It is known that the shorter the wavelength, the finer the pattern can be formed.

Among them, KrF laser (243 nm) photoresist is still being researched and developed to pursue optical micropatterning, even since ArF laser (193 nm) system was developed. One reason for this is that the development of next-generation ArF photoresist is not yet satisfactory in performance, and the second reason is that the use of KrF photoresist has a considerable cost reduction effect in mass production of semiconductor devices. In line with these technological developments, the performance of KrF photoresist needs to be improved. For example, since a photoresist film becomes thinner and thinner for higher-density integration, the development of a photoresist that is more resistant to dry etching is urgently required. Other required characteristics include high resolution, wide depth of focus (DOF) margins, integrity of films, adhesion to substrates, high contrast, fast sensitivity, and chemical stability.

There are related art patent documents regarding photoresist technology for KrF laser: Korean Patent Application Publication No. 10-2010-0047038, titled "Chemically Amplified Positive Photoresist Composition"; Korean Patent No. 10-1363842, titled " Chemically Amplified Positive Photoresist Composition and Resist Patterning Method Using the Same"; Korean Patent No. 10-1204915, titled "Photoresist Polymer, Photoresist Composition Comprising the Same, and Photoresist Patterning Method Using the Same"; Korean Patent No. 10-0273108, titled "Copolymer for Preparing Photoresist, and Chemically Amplified Positive Photoresist Composition Comprising the Same"; Korean Patent No. 10-1655947, titled "KrF laser Negative Photoresist Composition with High Resolution and High Aspect Ratio"; Korean Patent No. 10-1977886, titled " Chemically Amplified Positive Photoresist Composition for Improved Pattern Profile"; etc.

As described in the patent documents, KrF photoresists are largely based on polyhydroxystyrene and polystyrene polymers with good transmission at a wavelength of 248 nm for good resolution and sensitivity.

The positive photoresists based on polyhydroxystyrene and polystyrene polymers suffer from a limited range of possible uses in processes using 248-nm light sources due to slope patterning or footing phenomena. Furthermore, as the thickness of the photoresist increases, the resolution decreases. For these problems, it is difficult to proceed the process with the positive photoresists.

### [Documents of Related Art]

### (Patent Documents)

(Patent Document 1) Korean Patent Application Publication No. 10-2010-0047038
(Patent Document 2) Korean Patent No. 10-1363842
(Patent Document 3) Korean Patent No. 10-1204915
(Patent Document 4) Korean Patent No. 10-0273108
(Patent Document 5) Korean Patent No. 10-1655947
(Patent Document 6) Korean Patent No. 10-1977886

### Disclosure

### Technical Problem

The present disclosure provides a photoresist composition for a KrF light source, the photoresist composition being capable of improving the resolution compared to a conventional KrF positive photoresist by introducing an appropriate amount of an under-pattern acid generating aid that is effective in improving a pattern profile and improving a resolution. In addition, the present disclosure provides a photoresist composition for a KrF light source, the photoresist composition being capable of securing a vertical profile and being effective in removing residual scum generated under a pattern.

### Technical Solution

To accomplish the above objectives, the present disclosure provides a positive photoresist composition for a KrF laser, the composition including an under-pattern acid generating aid monomer additive for a chemically amplified photoresist, the monomer additive having a weight average molecular weight of 100 to 500 and comprising at least one selected from the group consisting of materials represented by Formula 1 to Formula 3 below.

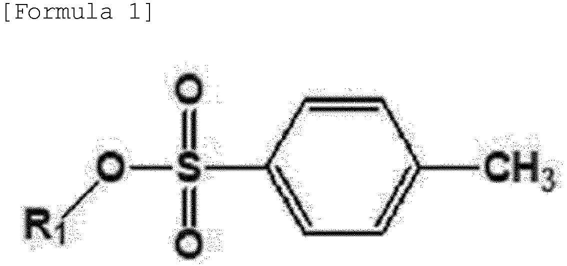

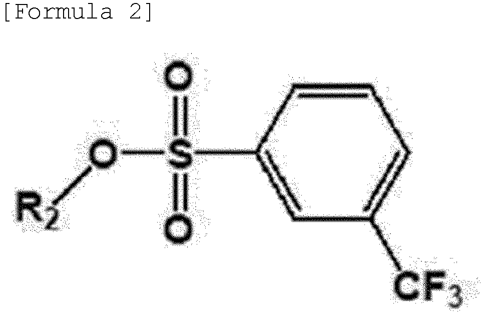

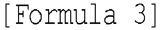

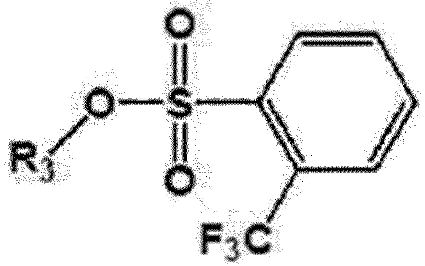

(In Formula 1 through Formula 3 above, R₁ through R₃ are structures selected from the structures represented by Formula A through Formula E below, with R denoting a bonding site).

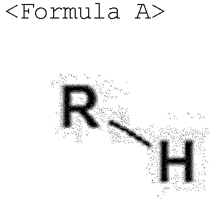

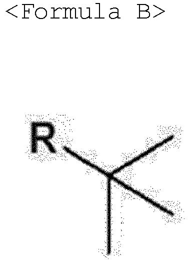

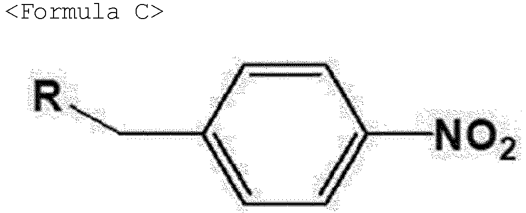

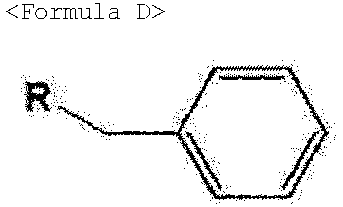

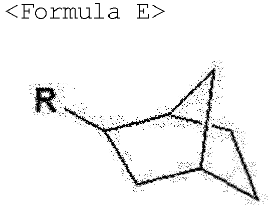

In one preferred embodiment of the present disclosure, the under-pattern acid generating aid monomer additives represented by the chemical formulae and similar structures thereof are commercially available from a number of domestic and international suppliers.

In one preferred embodiment of the present disclosure, the under-pattern acid generating aid monomer additive represented by the formula is characterized in that the monomer additive has a weight average molecular weight of 100 to 500.

In one preferred embodiment of the present disclosure, the under-pattern acid generating aid monomer additive represented by the formula may include, based on the total weight of the composition, 5 to 60 wt% of a polymer resin, 0.1 to 5 wt% of one or more under-pattern acid generating aid monomer additives selected from the group of materials represented by Formula 1 to Formula 3, 0.05 to 10 wt% of a photo acid generator, 0.01 to 5 wt% of an acid dispersion inhibitor, and the remainder of a solvent.

In one preferred embodiment of the present disclosure, the polymer resin may be any conventionally available photoresist resin and may be specifically at least one type selected from the group consisting of phenolic polymer resins containing hydroxyl groups and represented by Formula 4 to Formula 8 below.

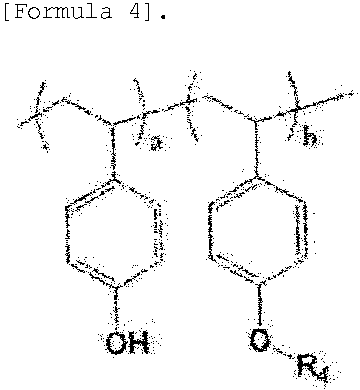

(In Formula 4 above, a and b are molar ratios of repeating units constituting the copolymer and are each independently any number in a range of 1 to 10 while a + b = 10, and R₄ is one structure selected from the structures of Formula a to Formula p below, with R denoting a bonding site).

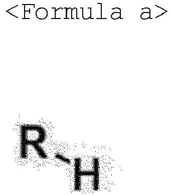

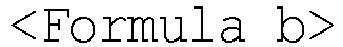

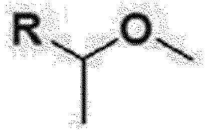

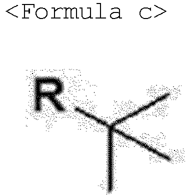

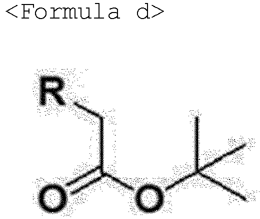

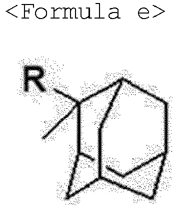

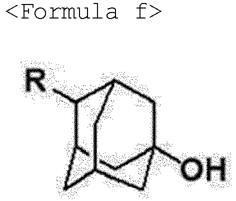

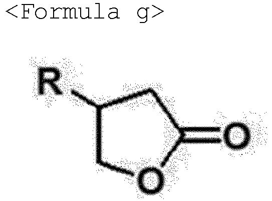

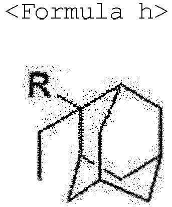

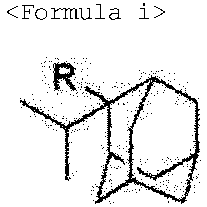

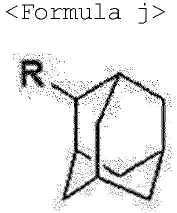

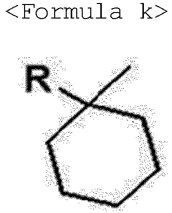

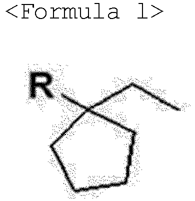

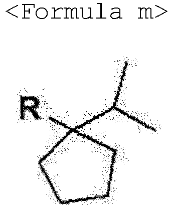

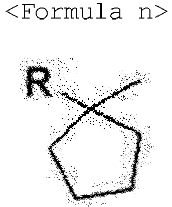

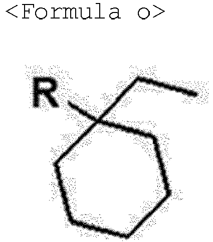

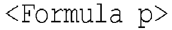

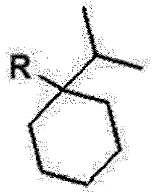

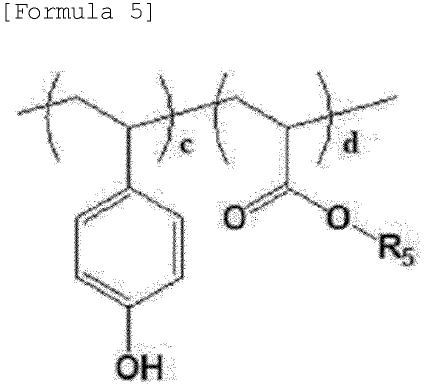

(In Formula 5 above, c and d are molar ratios of repeating units constituting the copolymer and are each independently a number in a range of 1 to 10 while c + d = 10, and R₅ is the same as R₄ and is one structure selected from the structures of Formula a to Formula p above, with R denoting a bonding site).

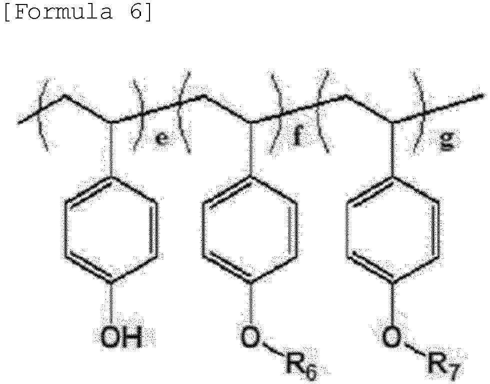

(In Formula 6 above, e, f, and g are molar ratios of repeating units constituting the copolymer and are each independently a number in a range of 1 to 10 wherein e + f + g = 10, and R₆ and R₇ are the same as R₄ and are one structure selected from the structures of Formula a to Formula p above, with R denoting a bonding site).

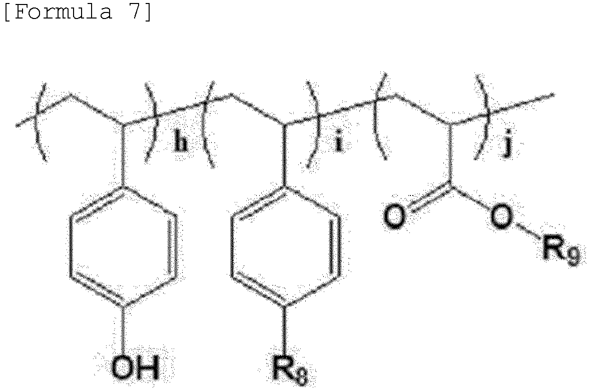

(In Formula 7 above, h, i, and j are molar ratios of repeating units constituting the copolymer and are each a number in a range of 1 to 10 where h + I + j = 10, and R₈ and R₉ are the same as R₄ and are one structure selected from the structures of Formula a to Formula p above, with R denoting a bonding site).

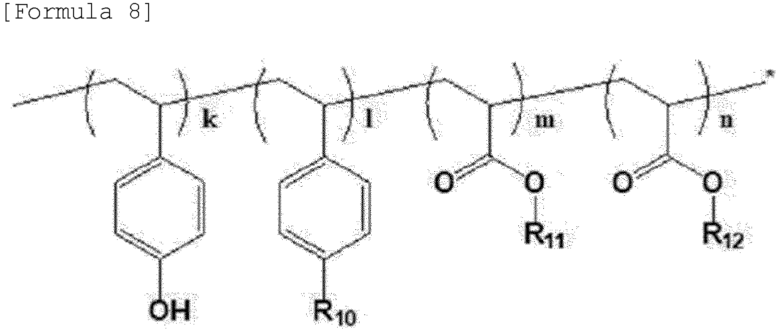

(In Formula 8 above, k, l, m, and n are molar ratios of repeating units constituting the copolymer and are each a number in a range of 1 to 10 where k + l + m + n = 10, and R₁₀, R₁₁, and R₁₂ are the same as R₄ and are one structure selected from the structures of Formula a to Formula p above, with R denoting a bonding site).

In one preferred embodiment of the present disclosure, the phenolic polymer resin may be at least one selected from the group consisting of phenolic polymer resins containing hydroxyl groups and represented by Formulas 4 to 8.

In one preferred embodiment of the present disclosure, the photo acid generator may be at least one selected from the group consisting of triphenylsulfoniumtriflate, triphenylsulfoniumantimonate, diphenyliodoniumtriflate, diphenyliodoniumantimonate, methoxydiphenyliodoniumtriflate, di-t-buthyldiphenyliodoniumtriflate, norbornenedicarboxyimidetriflate, triphenylsulfoniumnonaflate, diphenyliodoniumnonaflate, methoxydiphenyliodoniumnonaflate, di-t-buthyldiphenyliodoniumnonaflate, N-hydroxysuccinimidenonaflate, norbornenedicarboxyimidenonaflate, triphenylsulfoniumperfluorooctanesulfonate, diphenyliodoniumperfluorooctanesulfonate, methoxydiphenyliodoniumperfluorooctanesulfonate, di-t-butyldiphenyliodoniumperfluorooctanesulfonate, N-hydroxysuccinimideperfluorooctanesulfonate, and norbornenedicarboxyimideperfluorooctanesulfonate.

In one preferred embodiment of the present disclosure, the acid dispersion inhibitor may be at least one selected from the group consisting of dimethylamine, diethylamine, trimethylamine, triethylamine, tributhylamine, dimethanolamine, diethanolamine, trimethanolamine, triethanolamine, and tributhanolamine.

### Advantageous Effects

According to the present disclosure, the chemically amplified positive photoresist composition for improving pattern profile and resolution, which includes a monomer additive for generating acid under the pattern, can obtain a vertical profile according to the exposure energy, has the effect of improving sensitivity and resolution, and has the effect of removing residual scum under the pattern, so that the process margin can be improved compared to conventional KrF positive photoresists.

### Best Mode

Unless otherwise defined, all technical and scientific terms used herein have the same meaning as would be commonly understood by a person skilled in the art to which the present disclosure pertains. The nomenclature used herein is on that is well known and commonly used in the art.

Throughout this specification, when an element is referred to as "including" or "comprising" a component, the expression means the presence of the component but do not preclude the presence of other components, unless specifically stated to the contrary.

Herein, the term "under-pattern acid generating aid monomer additive" refers to an additive that is decomposed by heat to generate acid (H+) in the post-exposed bake (PEB) process, which is carried out after exposure to krypton fluoride (KrF) emitted from a 248 nm light source.

In the present disclosure, the term "photoresist" means a mixture of polymer and photo acid generator, which has chemical properties changed by light. Therefore, the solubility of the photoresist in a certain solvent changes when exposed to a certain wavelength of light, and thus a difference occurs in the dissolution rate of the exposed and non-exposed parts in the solvent, so that after a certain period of dissolution time, a part that is not completely dissolved remains and forms a pattern.

In the present disclosure, the term "photolithographic process" refers to a process in which a mask engraved with a semiconductor circuit using the properties of a photoresist as described above is placed between a light source and a photoresist film formed on a silicon wafer, and when the light source is turned on, the circuit engraved on the mask is transferred to the photoresist film.

As used herein, the term "KrF laser" refers to a krypton fluoride (KrF) laser having a wavelength of 248 nm.

One embodiment of the present disclosure provides a chemically amplified positive photoresist composition for improving pattern profile and resolution, the photoresist composition being characterized by including at least one under-pattern acid generating aid monomer additive selected from the group consisting of materials represented by Formula 1 to Formula 3 below.

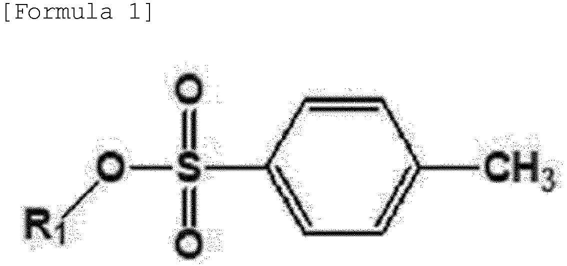

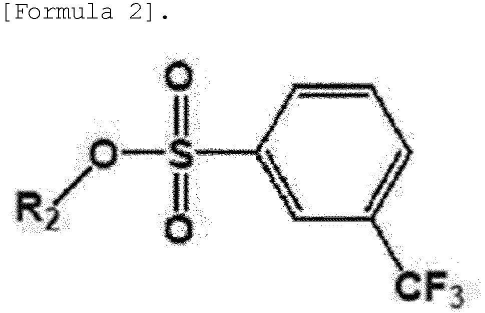

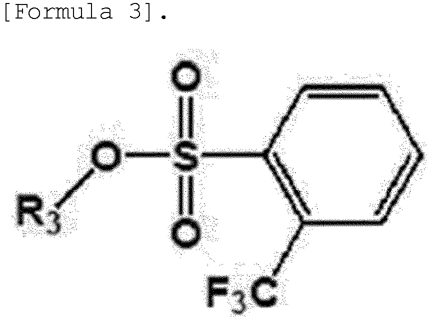

(In Formula 1 through Formula 3 above, R₁ through R₃ are structures selected from the structures of Formula A through Formula E below, with R denoting a bonding site).

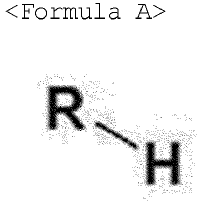

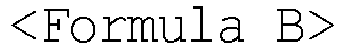

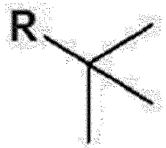

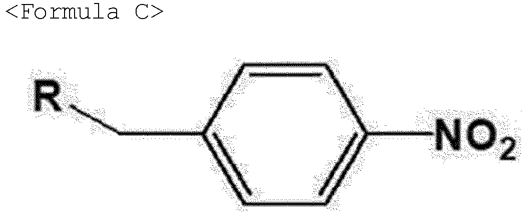

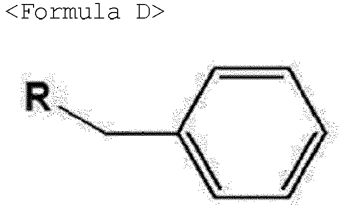

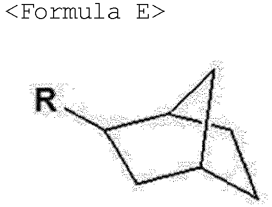

The positive photoresist composition containing the under-pattern acid generating aid monomer additive according to the present disclosure may include, based on the total weight of the composition, 5 to 60 wt% of a polymer resin, 0.1 to 5 wt% of one or more under-pattern acid generating aid monomer additives selected from the group consisting of materials represented by Formula 1 to Formula 3, 0.05 to 10 wt% of a photo acid generator, 0.01 to 5 wt% of an acid dispersion inhibitor, and the remainder of a solvent.

Preferably, the one or more under-pattern acid generating aid monomer additives selected from the group consisting of materials represented by Formula 1 to Formula 3 may be included in an amount of 0.1 to 5 wt%, based on the total weight of the composition. When the monomer additives are included in an amount of less than 0.1 wt%, it is difficult to secure a vertical profile and is insufficient to improve the resolution. When the amount of the monomer additives is more than 5 wt%, a vertical profile can be secured, but it is not desirable because a pattern collapse or undercut occurs due to excessive acid generation under the pattern.

The polymer resin may be any conventionally used photoresist resin, and may be at least one type selected from the group consisting of phenolic polymeric resins containing hydroxyl groups and represented by Formula 4 to Formula 8.

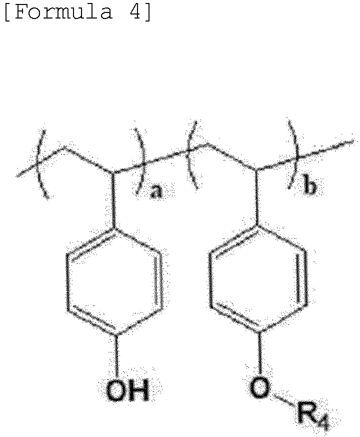

(In Formula 4 above, a and b are molar ratios of repeating units constituting the copolymer and are each a number in a range of 1 to 10 where a + b = 10, and R₄ is one structure selected from the structures of Formula a to Formula p below, with R denoting a bonding site).

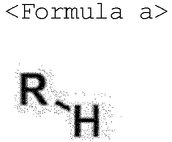

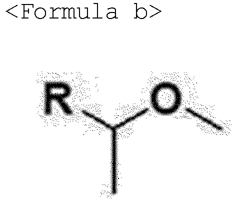

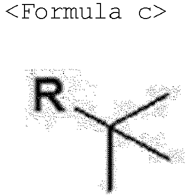

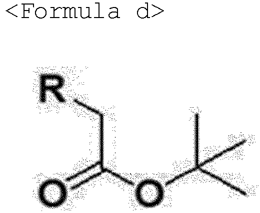

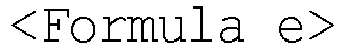

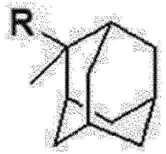

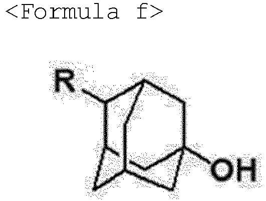

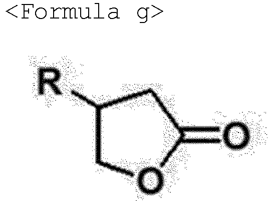

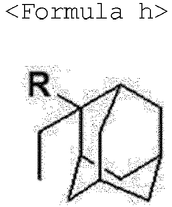

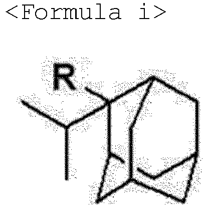

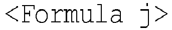

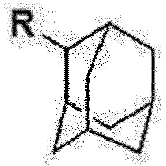

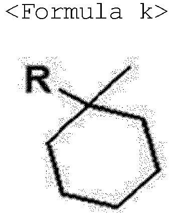

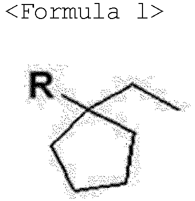

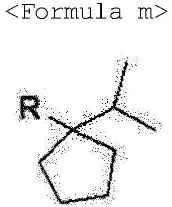

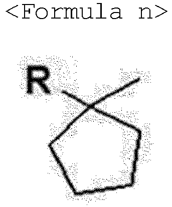

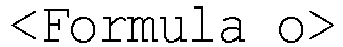

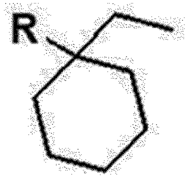

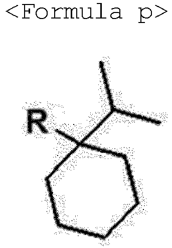

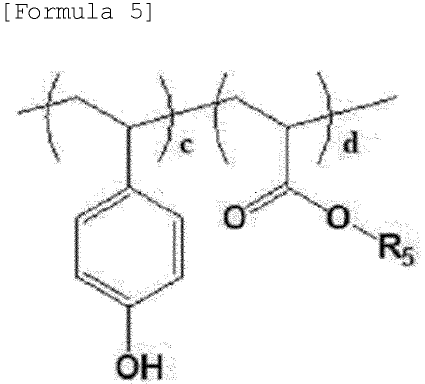

(In Formula 5 above, c and d are molar ratios of repeating units constituting the copolymer and are each in a range of 1 to 10 where c + d = 10, and R₈ is the same as R₄ and is one structure selected from the structures of Formula a to Formula p above, with R denoting a bonding site) .

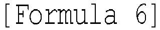

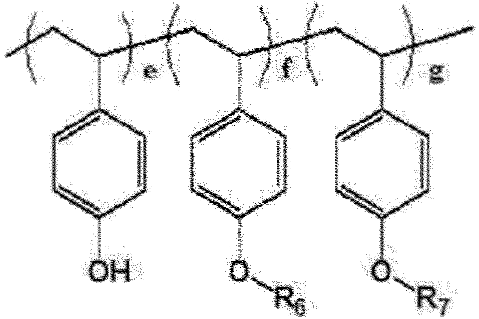

(In Formula 6 above, e, f, and g are molar ratios of repeating units constituting the copolymer and are each in a range of 1 to 10 where e + f + g = 10, and R₆ and R₇ are the same as R₄ and are one structure selected from the structures of Formula a to Formula p above, with R denoting a bonding site).

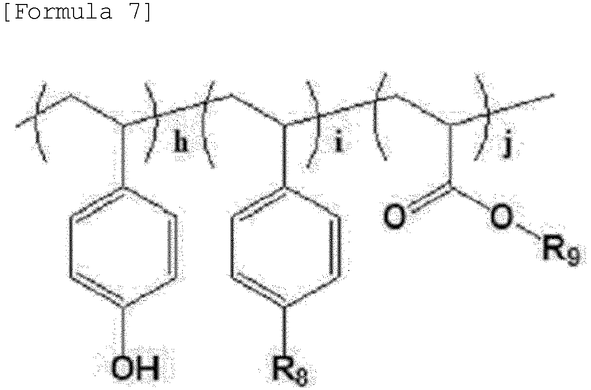

(In Formula 7 above, h, i, and j are molar ratios of repeating units constituting the copolymer are each in a range of 1 to 10 where h + I + j = 10, and R₈ and R₉ are the same as R₄ and are one structure selected from the structures of Formula a to Formula p above, with R denoting a bonding site).

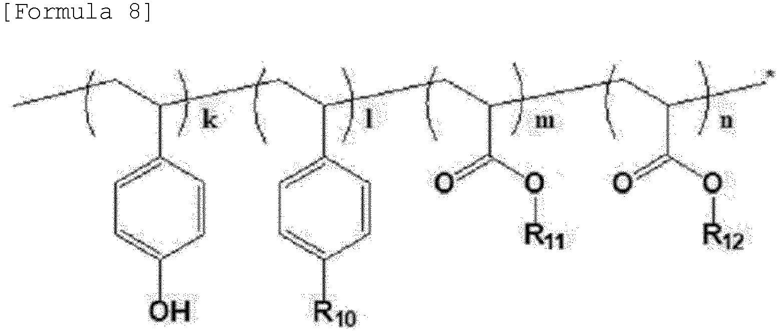

(In Formula 8 above, k, l, m, and n are molar ratios of repeating units constituting the copolymer and are each in a range of 1 to 10 where k + l + m + n = 10, and R₁₀, R₁₁, and R₁₂ are the same as R₄ and are one structure selected from the structures of Formula a to Formula p above, with R denoting a bonding site).

In one preferred embodiment of the present disclosure, the phenolic polymer resin is at least one selected from the group consisting of phenolic polymer resins containing hydroxyl groups and represented by Formula 4 to Formula 8 below.

The polymer resin is preferably contained in an amount of 5 to 60 wt% based on the total weight of the composition. When the content of the polymer resin is less than 5 wt%, there may be problems such as poor profile, scum generation, and poor etch resistance. When the content of the polymer resin is more than 60 wt%, there may be problems such as poor patterning due to insufficient development.

The photo acid generator may be at least one selected from the group consisting of triphenylsulfoniumtriflate, triphenylsulfoniumantimonate, diphenyliodoniumtriflate, diphenyliodoniumantimonate, methoxydiphenyliodoniumtriflate, di-t-buthyldiphenyliodoniumtriflate, norbornenedicarboxyimidetriflate, triphenylsulfoniumnonaflate, diphenyliodoniumnonaflate, methoxydiphenyliodoniumnonaflate, di-t-buthyldiphenyliodoniumnonaflate, N-hydroxysuccinimidenonaflate, norbornenedicarboxyimidenonaflate, triphenylsulfoniumperfluorooctanesulfonate, diphenyliodoniumperfluorooctanesulfonate, methoxydiphenyliodoniumperfluorooctanesulfonate, di-t-butyldiphenyliodoniumperfluorooctanesulfonate, N-hydroxysuccinimideperfluorooctanesulfonate, and norbornenedicarboxyimideperfluorooctanesulfonate.

The photo acid generator is preferably included in an amount of 0.05 to 10 wt% based on the total weight of the composition. When the content of the photo acid generator is less than 0.05 wt%, the pattern slope may be aggravated due to the lack of acid generated. When the content is more than 10 wt%, the photo acid generator may absorb the light emitted from the light source and reduce the transmittance of the light, resulting in pattern defects such as an undefined pattern.

The acid dispersion inhibitor may be at least one type selected from the group consisting of dimethylamine, diethylamine, trimethylamine, triethylamine, tributhylamine, dimethanolamine, diethanolamine, trimethanolamine, triethanolamine, and tributhanolamine.

Preferably, the acid dispersion inhibitor may be included in an amount of 0.01 to 5 wt% based on the total weight of the composition. When the content of the acid dispersion inhibitor is less than 0.01 wt%, there is a problem that excessive acid generation may cause a pattern defect such as a defective pattern (LWR, LER) on the wall or corner of the pattern, and when the content is more than 5 wt%, it may be impossible to form a pattern.

On the other hand, the chemically amplified positive photoresist composition for improving a pattern profile and resolution, containing the under-pattern acid generating aid monomer, according to the present disclosure can be used to a photoresist film with a thickness in a range of from 2,000 Å to 200, 000 Å depending on the type and amount of the solvent used, and the chemically amplified positive photoresist composition may be used after being dissolved in an amount of 10 to 90 wt% by weight with respect to the weight of the solvent.

As the solvent, the following may be used solely or in combination as a mixture: ethyleneglycolmonomethylether, ethyleneglycolmonoethylether, methylcellosolveacetate, ethylcellosolveacetate, diethyleneglycolmonomethylether, diethyleneglycolmonoethylether, propyleneglycolMonomethylether, propyleneglycolmethyletheracetate, propyleneglycolpropyletheracetate, diethyleneglycoldimethylether, ethylactate, toluene, xylene, methylethylketone, cyclohexanone, 2-heptanone, 3-heptanone, 4-heptanone, and the like.

As described above, the chemically amplified positive photoresist composition for improving a pattern profile and resolution, containing one or more under-pattern acid generating aid monomer additives selected from the group consisting of materials represented by Formula 1 to Formula 3, according to the present invention can provide a vertical profile as a function of exposure energy and has the effects of resolution improvement and bottom residual scum removal, thereby providing a wider process margin than conventional KrF photoresists.

### Mode for the invention

### [Example and Comparative Example]

The present disclosure will now be described in more detail with reference to examples. These examples are intended solely to illustrate the present disclosure, and it will be apparent to those who are skilled in the art that the scope of the present disclosure is not to be construed as being limited by these examples.

### Example 1

A positive photoresist composition for KrF excimer laser was prepared by using: 100 g of a phenolic polymer resin with a weight average molecular weight of 15,000 as a base resin (structure in which R₈ in Formula 7 is Formula a, R₉ in Formula 7 is Formula c, the copolymerization molar ratios h, i, and j are 7, 2, and 1, respectively); 1.00 g of an under-pattern acid generating aid monomer additive (structure in which R₁ in Formula 1 is Formula d) with a weight average molecular weight of 270; 4 g of triphenylsulfonium nonaflate as a photo acid generator; 0.6 g of triethanolamine as an acid dispersion inhibitor; and a solvent. The solvent was a mixture of 105 g of propylene glycol monomethyl ether and 105 g of propylene glycol methyl ether acetate. The prepared composition was applied onto a silicon wafer using a spin coater and soft baked at 140°C for 90 seconds to achieve a target thickness of 10 µm. The coating was exposed to a 248-nm light source, underwent a baking process (PEB) at 110°C for 80 seconds, and underwent a development process with 2.38% tetramethylammonium hydroxide to produce a pattern. As a result, a positive slope pattern with a pattern slope inclination angle of 82.7°, a sensitivity of 96 mJ/cm², and a line/space resolution of 2.5 um was confirmed, and no residual scum was found under the pattern.

### Example 2

A positive photoresist composition for KrF excimer laser was prepared by using: 100 g of a phenolic polymer resin with a weight average molecular weight of 15,000 as a base resin (structure in which R₈ in Formula 7 is Formula a, R₉ in Formula 7 is Formula c, the copolymerization molar ratios h, i, and j are 7, 2, and 1, respectively); 10.00 g of an under-pattern acid generating aid monomer additive (structure in which R₁ in Formula 1 is Formula d) with a weight average molecular weight of 270; 4 g of triphenylsulfonium nonaflate as a photo acid generator; 0.6 g of triethanolamine as an acid dispersion inhibitor; and a solvent. The solvent was a mixture of 114 g of propylene glycol monomethyl ether and 114 g of propylene glycol methyl ether acetate. The prepared composition was applied onto a silicon wafer using a spin coater and soft baked at 140°C for 90 seconds to achieve a target thickness of 10 µm. The coating was exposed to a 248-nm light source, underwent a baking process (PEB) at 110°C for 80 seconds, and underwent a development process with 2.38% tetramethylammonium hydroxide to produce a pattern. As a result, a positive slope pattern with a pattern slope inclination angle of 84.3°, a sensitivity of 92 mJ/cm², and a line/space resolution of 2.2 um was confirmed, and no residual scum was found under the pattern.

### Example 3

A positive photoresist composition for KrF excimer laser was prepared by using: 100 g of a phenolic polymer resin with a weight average molecular weight of 15,000 as a base resin (structure in which R₈ in Formula 7 is Formula a, R₉ in Formula 7 is Formula c, the copolymerization molar ratios h, i, and j are 7, 2, and 1, respectively); 15.00 g of an under-pattern acid generating aid monomer additive (structure in which R₁ in Formula 1 is Formula d) with a weight average molecular weight of 270; 4 g of triphenylsulfonium nonaflate as a photo acid generator; 0.6 g of triethanolamine as an acid dispersion inhibitor; and a solvent. The solvent was a mixture of 119 g of propylene glycol monomethyl ether and 119 g of propylene glycol methyl ether acetate. The prepared composition was applied onto a silicon wafer using a spin coater and soft baked at 140°C for 90 seconds to achieve a target thickness of 10 µm. The coating was exposed to a 248-nm light source, underwent a baking process (PEB) at 110°C for 80 seconds, and underwent a development process with 2.38% tetramethylammonium hydroxide to produce a pattern. As a result, a positive slope pattern with a pattern slope inclination angle of 86.5°, a sensitivity of 88 mJ/cm², and a line/space resolution of 2.0 um was confirmed, and no residual scum was found under the pattern.

### Comparative Example 1

The experiment was conducted in the same manner as in Example 1, except that the under-pattern acid generating aid monomer additive was not added and a mixture of 104 g of propylene glycol monomethyl ether and 104 g of propylene glycol methyl ether acetate was used as the solvent.

Specifically, a positive photoresist composition for KrF excimer laser was prepared by using: 100 g of a phenolic polymer resin with a weight average molecular weight of 15,000 as a base resin (structure in which R₈ in Formula 7 is Formula a, R₉ in Formula 7 is Formula c, the copolymerization molar ratios h, i, and j are 7, 2, and 1, respectively); 0 g of an under-pattern acid generating aid monomer additive (structure in which R₁ in Formula 1 is Formula d) with a weight average molecular weight of 270; 4 g of triphenylsulfonium nonaflate as a photo acid generator; 0.6 g of triethanolamine as an acid dispersion inhibitor; and a solvent. The solvent was a mixture of 104 g of propylene glycol monomethyl ether and 104 g of propylene glycol methyl ether acetate. The prepared composition was applied onto a silicon wafer using a spin coater and soft baked at 140°C for 90 seconds to achieve a target thickness of 10 µm. The coating was exposed to a 248-nm light source, underwent a baking process (PEB) at 110°C for 80 seconds, and underwent a development process with 2.38% tetramethylammonium hydroxide to produce a pattern.

As a result, a positive slope pattern with a pattern slope inclination angle of 74.5°, a sensitivity of 110 mJ/cm², and a line/space resolution of 3.5 um was confirmed, and residual scum was found under the pattern.

### Comparison Example 2

The experiment was conducted in the same manner as in Comparative Example 1, except that the under-pattern acid generating aid monomer additive was added in an amount of 0.25 g.

Specifically, a positive photoresist composition for KrF excimer laser was prepared by using: 100 g of a phenolic polymer resin with a weight average molecular weight of 15,000 as a base resin (structure in which R₈ in Formula 7 is Formula a, R₉ in Formula 7 is Formula c, the copolymerization molar ratios h, i, and j are 7, 2, and 1, respectively); 0.25 g of an under-pattern acid generating aid monomer additive (structure in which R₁ in Formula 1 is Formula d) with a weight average molecular weight of 270; 4 g of triphenylsulfonium nonaflate as a photo acid generator; 0.6 g of triethanolamine as an acid dispersion inhibitor; and a solvent. The solvent was a mixture of 104 g of propylene glycol monomethyl ether and 104 g of propylene glycol methyl ether acetate. The prepared composition was applied onto a silicon wafer using a spin coater and soft baked at 140°C for 90 seconds to achieve a target thickness of 10 µm. The coating was exposed to a 248-nm light source, underwent a baking process (PEB) at 110°C for 80 seconds, and underwent a development process with 2.38% tetramethylammonium hydroxide to produce a pattern.

As a result, a positive slope pattern with a pattern slope inclination angle of 79.6°, a sensitivity of 100 mJ/cm², and a line/space resolution of 3.0 um was confirmed, and residual scum was found under the pattern.

### Comparative Example 3

The experiment was conducted in the same manner as in Comparative Example 1, except that the under-pattern acid generating aid monomer additive was added in an amount of 30,00 g, and a mixture of 133 g of propylene glycol monomethyl ether and 133 g of propylene glycol methyl ether acetate was used as the solvent.

Specifically, a positive photoresist composition for KrF excimer laser was prepared by using: 100 g of a phenolic polymer resin with a weight average molecular weight of 15,000 as a base resin (structure in which R₈ in Formula 7 is Formula a, R₉ in Formula 7 is Formula c, the copolymerization molar ratios h, i, and j are 7, 2, and 1, respectively); 30.00 g of an under-pattern acid generating aid monomer additive (structure in which R₁ in Formula 1 is Formula d) with a weight average molecular weight of 270; 4 g of triphenylsulfonium nonaflate as a photo acid generator; 0.6 g of triethanolamine as an acid dispersion inhibitor; and a solvent. The solvent was a mixture of 133 g of propylene glycol monomethyl ether and 133 g of propylene glycol methyl ether acetate. The prepared composition was applied onto a silicon wafer using a spin coater and soft baked at 140°C for 90 seconds to achieve a target thickness of 10 µm. The coating was exposed to a 248-nm light source, underwent a baking process (PEB) at 110°C for 80 seconds, and underwent a development process with 2.38% tetramethylammonium hydroxide to produce a pattern. As a result, a positive slope pattern with a pattern slope inclination angle of 87.3°, a sensitivity of 83 mJ/cm², and a line/space resolution of 1.8 um was confirmed, and no residual scum was found under the pattern.

### Characteristics Measurement

The characteristics of the pattern profiles and chemically amplified positive photoresist compositions for improving a pattern profile and resolution, prepared as in Examples 1 to 3 and Comparative Example 1 to 3 were measured.

The resolution and under-pattern residual scum were measured using a critical dimension-scanning electron microscope (CD-SEM) with which the linewidth of a pattern can be observed. For the resolution, the minimum linewidth (resolution) based on line-and-spacing (L/S) was observed and confirmed. In addition, the sensitivity was measured by sensing the energy with which the minimum linewidth (resolution) can be observed.

The results of these measurements are shown in Table 1 below.

**[Table 1**

| | Sensitivity (mJ/cm²) | Resolution (µm) | Pattern Angle (°) | Residue, Scum |
|---|---|---|---|---|
| Example 1 | 96 | 2.5 | 82.7 | Free |
| Example 2 | 92 | 2.2 | 84.3 | Free |
| Example 3 | 88 | 2.0 | 86.5 | Free |
| Comparative Example 1 | 110 | 3.5 | 74.5 | Scum, Residue |
| Comparative Example 2 | 100 | 3.0 | 79.6 | Scum, Residue |
| Comparative Example 3 | 83 | 1.8 | 87.3 | Free, Pattern collapse |

As can be seen from Table 1 above, the evaluation results of the addition of the under-pattern acid generating aid monomer additive show that Examples 1 to 3 have better sensitivity than Comparative Examples 1 and 2, and Examples 1 to 3 exhibit significant improvements in the minimum linewidth indicating the resolution and in vertical pattern slope.

In the case of Comparative Examples 1 and 2, the CD-SEM results show residual scum beneath the pattern, which means that the compositions cannot be adopted.

In addition, Comparative Example 2 has an improvement in resolution and vertical pattern slope compared to Comparative Example 1, but since the improvement is extremely marginal compared to Examples 1 to 3, the composition of Comparative Example 2 cannot be adopted.

Although Comparative Example 3 shows improvements in sensitivity, resolution (minimum linewidth), and vertical pattern slope compared to Comparative Example 1, the composition cannot be adopted because catastrophic pattern collapse is observed to occur in some regions.

In conclusion, it has been confirmed that the inclusion of an optimal content of the under-pattern acid generating aid monomer additives of Formula 1 to Formula 3 can improve the sensitivity and resolution of the formed pattern. That is, the present disclosure can provide a photoresist composition for a KrF light source that exhibits an improved vertical profile compared to a conventional KrF positive photoresist.

All simple variations or modifications to the present disclosure may be readily practiced by the ordinarily skilled in the art, and all such variations or modifications may be deemed to fall within the scope of the present disclosure.

## Claims

1. A chemically amplified positive photoresist composition for improving a pattern profile and resolution, the photoresist composition being capable of being lithographed with a light source having a wavelength of 248 nm, the photoresist composition comprising 0.1 to 5 wt% by weight of an under-pattern acid generating aid monomer additive represented by Formula 1 to Formula 3 below: 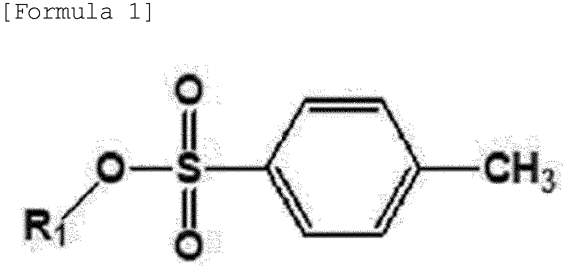 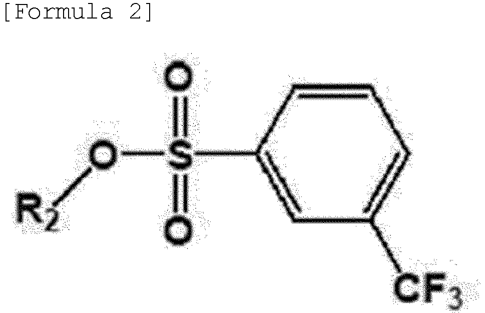 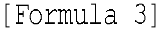 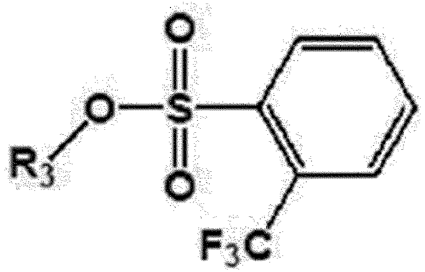 (in Formula 1 through Formula 3 above, R₁ through R₃ are structures selected from structures represented by Formula A through Formula E below, with R denoting a bonding site),

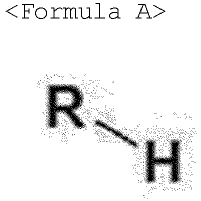

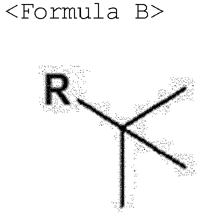

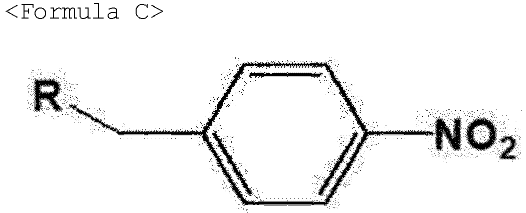

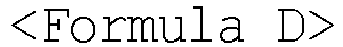

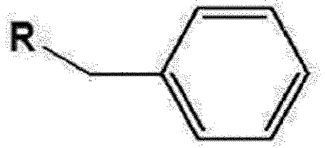

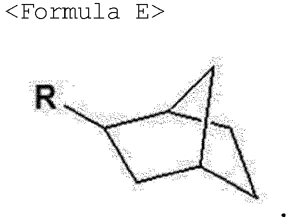

2. The photoresist composition of claim 1, wherein the photoresist composition comprises, based on the total weight of the composition, 5 to 60 wt% of a polymer resin, 0.1 to 5 wt% of the under-pattern acid generating aid monomer additive represented by Formula 1 to Formula 3, 0.05 to 10 wt% of a photo acid generator, 0.01 to 5 wt% of an acid dispersion inhibitor, and the remainder of a solvent.

3. The photoresist composition of claim 1, wherein the polymer resin is a phenolic polymer resin containing at least one hydroxyl group and selected from the group consisting of materials represented by Formula 4 to Formula 8 below: 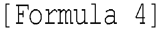 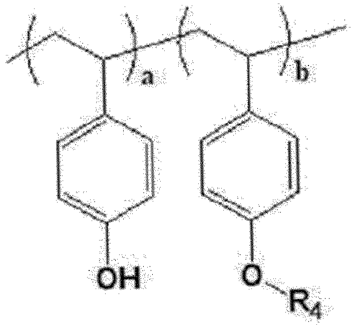 (in Formula 4 above, a and b are molar ratios of repeating units constituting a copolymer and are each a number in a range of 1 to 10 where a + b = 10, and R₄ is one structure selected from structures represented by Formula a to Formula p below, with R denoting a bonding site), 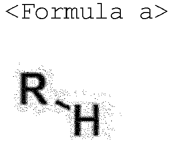 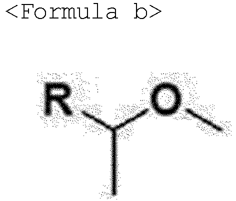 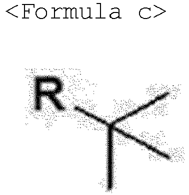 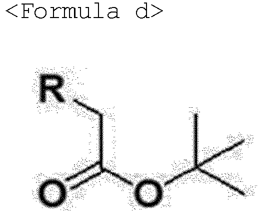 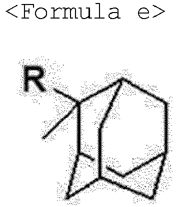 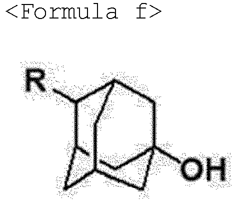 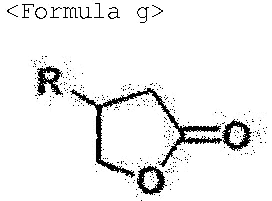 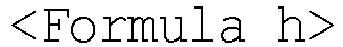 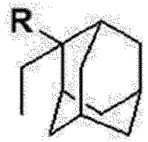 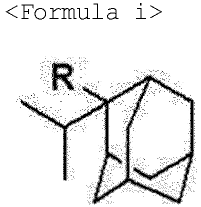 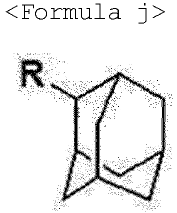 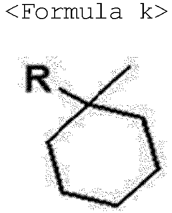 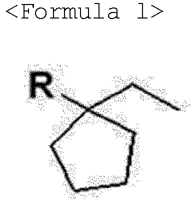 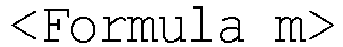 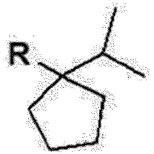 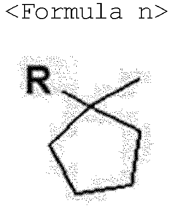 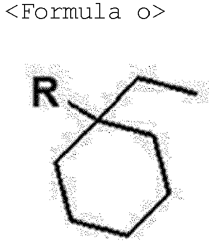 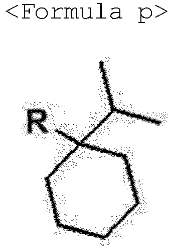 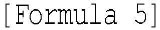 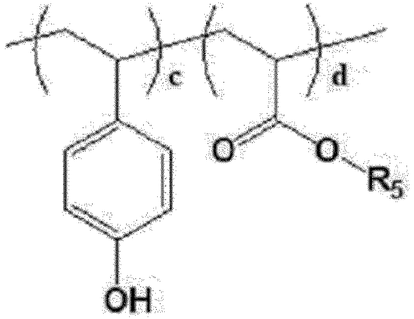 (in Formula 5 above, c and d are molar ratios of repeating units constituting the copolymer are each a number in a range of 1 to 10 where c + d = 10, and R₈ is the same as R₄ and is one structure selected from the structures represented by Formula a to Formula p above, with R denoting a bonding site), 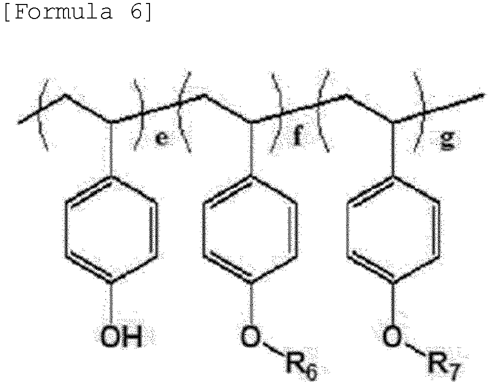 (in Formula 6 above, e, f, and g are molar ratios of repeating units constituting the copolymer and are each a number in a range of 1 to 10 where e + f + g = 10, and R₆ and R₇ are the same as R₄ and are one structure selected from the structures represented by Formula a to Formula p above, with R denoting a bonding site), 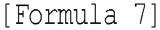 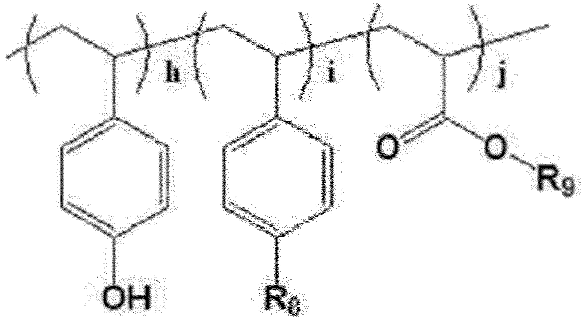 (in Formula 7 above, h, i, and j are molar ratios of repeating units constituting the copolymer and are each in a range of 1 to 10 where h + I + j = 10, and R₈ and R₉ are the same as R₄ and are one structure selected from the structures represented by Formula a to Formula p above, with R denoting a bonding site), 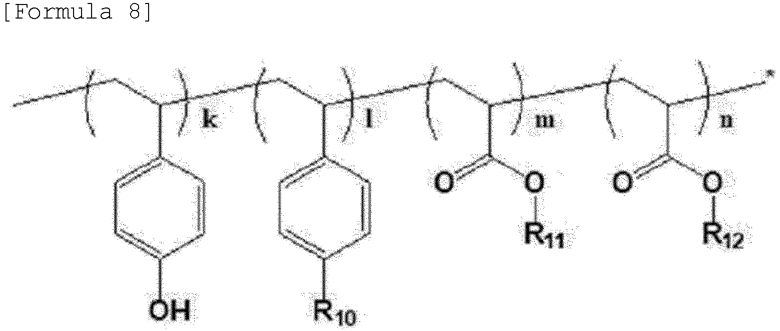 (in Formula 8 above, k, l, m, and n are molar ratios of repeating units constituting the copolymer and are each in a range of 1 to 10 where k + l + m + n = 10, and R₁₀, R₁₁, and R₁₂ are the same as R₄ and are one structure selected from the structures represented by Formula a to Formula p above, with R denoting a bonding site).

4. The photoresist composition of claim 1, wherein the photo acid generator comprises at least one selected from the group consisting of triphenylsulfoniumtriflate, triphenylsulfoniumantimonate, diphenyliodoniumtriflate, diphenyliodoniumantimonate, methoxydiphenyliodoniumtriflate, di-t-buthyldiphenyliodoniumtriflate, norbornenedicarboxyimidetriflate, triphenylsulfoniumnonaflate, diphenyliodoniumnonaflate, methoxydiphenyliodoniumnonaflate, di-t-buthyldiphenyliodoniumnonaflate, N-hydroxysuccinimidenonaflate, norbornenedicarboxyimidenonaflate, triphenylsulfoniumperfluorooctanesulfonate, diphenyliodoniumperfluorooctanesulfonate, methoxydiphenyliodoniumperfluorooctanesulfonate, di-t-butyldiphenyliodoniumperfluorooctanesulfonate, N-hydroxysuccinimideperfluorooctanesulfonate, and norbornenedicarboxyimideperfluorooctanesulfonate.

5. The photoresist composition of claim 1, wherein the acid dispersion inhibitor comprises at least one selected from the group consisting of dimethylamine, diethylamine, trimethylamine, triethylamine, tributhylamine, dimethanolamine, diethanolamine, trimethanolamine, triethanolamine, and tributhanolamine.
